# EUROPEAN PATENT APPLICATION

(11) **EP 4 717 792 A1**
(43) Date of publication of application: **01.04.2026**
(21) Application number: 25199560.1
(22) Date of filing: 02.09.2025
(51) Int. Cl.: C23C 4/11, C23C 4/134, C23C 4/18, C23C 14/08, C23C 14/32, C23C 14/58, C23C 28/04

(54) **COMPONENTS WITH THERMAL BARRIER COATINGS HAVING SOLID FILMS THEREON AND METHODS OF COATING THE SAME**

(30) Priority: 27.09.2024 US 202418899691
(71) Applicant: Honeywell International Inc., Charlotte, NC 28202 (US)
(72) Inventor: VAN SLUYTMAN, Jason, Charlotte, 28202 (US); TOLPYGO, Vladimir, Charlotte, 28202 (US)
(74) Representative: Ingrassia, Fisher & Lorenz UK Ltd.

(57) **Abstract**

Components and methods for coating the components are provided. The methods include depositing a coating composition on a substrate that includes about 3-50 wt.% rare-earth oxides, 45-96.5 wt.% zirconia, and 0.5-4 wt.% alumina, heat treating the coating composition to form a CMAS-resistant thermal barrier coating (TBC) that includes a columnar microstructure with voids in open communication with a surface thereof, wherein the alumina is homogeneously distributed throughout the TBC, contacting the TBC with a film precursor, transporting the film precursor along interior wall surfaces of the voids to form a thin film thereon, wherein the thin film has a thickness on the interior wall surfaces of 10-150 nm, and forming a solid film on the interior wall surfaces of the voids from the film precursor that includes aluminum phosphate and that does not fill the voids that have diameters of 50 nm or greater.

## Description

### TECHNICAL FIELD

The present invention generally relates to thermal barrier coatings (TBCs), and more particularly relates to TBCs for protecting parts from calcia-magnesia-alumina-silicate (CMAS)-induced damage.

### BACKGROUND

Many components utilized in high-temperature environments, such as those utilized in gas turbine engines, include parts with a thermal barrier coating (TBC) to protect the part against thermal and/or oxidative damage. As demands for higher turbine efficiency have led to increasingly high operating temperatures, the need for high-performance TBCs has also increased. Conventional TBCs are typically made of a ceramic material, have low thermal conductivity, and are applied on parts designed to operate in particularly hot sections of the turbine (e.g. blades, vanes, airfoils, etc.). Such parts are typically made from substrates comprising a superalloy, which are susceptible to thermal and oxidative degradation or damage from external sources under normal operating conditions, and thus include the TBC to preserve function and extend the life of the part.

During normal operation of gas turbine engines, dust (e.g. from ash, sand, salt, etc.) may be ingested into hot sections of the engine, where it can become molten or volatize as hydroxides and react with the TBC. The molten/reactive species from such occurrences is typically referred to as "calcia-magnesia- alumina-silicate" or "calcium magnesium aluminosilicate" (CMAS) due the predominance of these elements therein. The reactive CMAS species may penetrate into the TBC via liquid-phase and/or vapor-phase infiltration of CMAS constituents into pores of the TBC over time and can potentially cause issues such as promoting spallation. Therefore, it is desirable for TBCs to have high CMAS-resistance to reduce the likelihood of such issues occurring during operation.

As operating temperatures of gas turbine engines increase, there is an ongoing desire for TBCs having improved CMAS-resistance. Furthermore, other desirable features and characteristics of the present invention will become apparent from the subsequent detailed description and the appended claims, taken in conjunction with the accompanying drawings and the foregoing technical field and background.

### BRIEF SUMMARY

This summary is provided to describe select concepts in a simplified form that are further described in the Detailed Description. This summary is not intended to identify key or essential features of the claimed subject matter, nor is it intended to be used as an aid in determining the scope of the claimed subject matter.

In various examples, a method is provided for coating an article that includes depositing a coating composition on a substrate, the coating composition comprising: from about 3 to about 50 weight percent (wt.%) of one or more rare-earth oxides, from about 45 to about 96.5 wt.% zirconia, and from about 0.5 to about 4 wt.% alumina (each based on the total weight of the coating composition), heat treating the substrate with the coating composition thereon to form a calcia-magnesia-alumina-silicate (CMAS)-resistant thermal barrier coating (TBC) on the substrate, wherein the CMAS-resistant TBC includes a columnar microstructure with voids in open communication with a surface thereof, wherein the alumina is deposited substantially homogeneously distributed throughout the CMAS-resistant TBC, contacting the CMAS-resistant TBC with a film precursor, transporting the film precursor along interior wall surfaces of the voids of the CMAS-resistant TBC to form a thin film thereon, wherein the thin film has a thickness on the interior wall surfaces of at least 10 nm and less than 150 nm, and forming a solid film on the interior wall surfaces of the voids from the film precursor, wherein the solid film includes aluminum phosphate, wherein the solid film does not completely fill at least some of the voids that have diameters of 50 nm or greater.

In various examples, a component of a gas turbine engine is provided that includes a substrate, a calcia-magnesia-alumina-silicate (CMAS)-resistant thermal barrier coating (TBC) on the substrate, wherein the CMAS-resistant TBC is formed from a coating composition comprising from about 3 to about 50 wt.% of one or more rare-earth oxides, from about 45 to about 96.5 wt.% zirconia, and from about 0.5 to about 4 wt.% alumina (each based on the total weight of the coating composition), wherein the alumina is deposited substantially homogeneously distributed throughout the CMAS-resistant TBC, wherein the CMAS-resistant TBC includes a columnar microstructure with voids in open communication with a surface thereof, and a solid film on the interior wall surfaces of the voids of the CMAS-resistant TBC, wherein the solid film includes aluminum phosphate, wherein the solid film does not completely fill at least some of the voids that have diameters of 50 nm or greater.

Furthermore, other desirable features and characteristics of the method and component will become apparent from the subsequent detailed description and the appended claims, taken in conjunction with the accompanying drawings and the preceding background.

### BRIEF DESCRIPTION OF DRAWINGS

The present disclosure will hereinafter be described in conjunction with the following drawing figures, wherein like numerals denote like elements, and wherein:
FIG. 1 is a cross-sectional view schematically representing an exemplary gas turbine engine that includes a coated article in accordance with an embodiment;
FIG. 2 is a flowchart illustrating an exemplary method for coating an article in accordance with an embodiment;
FIG. 3 is a partial cross-sectional view representing an as-deposited coating composition layer on a substrate in accordance with an embodiment;
FIG. 4 is a partial cross-sectional view representing a calcia-magnesia-alumina-silicate (CMAS)-resistant thermal barrier coating (TBC) formed from the as-deposited coating composition layer of FIG. 3 in accordance with an embodiment;
FIG. 5 is a partial cross-sectional view representing a thin film of an as-deposited film precursor on the CMAS-resistant TBC of FIG. 4 in accordance with an embodiment; and
FIG. 6 is a partial cross-sectional view representing a coated article having a CMAS-resistant TBC with a solid film formed on interior wall surfaces of voids of the CMAS-resistant TBC in accordance with an embodiment;

### DETAILED DESCRIPTION

The following detailed description is merely exemplary in nature and is not intended to limit the invention or the application and uses of the invention. As used herein, the word "exemplary" means "serving as an example, instance, or illustration." Thus, any embodiment described herein as "exemplary" is not necessarily to be construed as preferred or advantageous over other embodiments. All of the embodiments described herein are exemplary embodiments provided to enable persons skilled in the art to make or use the invention and not to limit the scope of the invention which is defined by the claims. Furthermore, there is no intention to be bound by any expressed or implied theory presented in the preceding technical field, background, brief summary, or the following detailed description.

Broadly, embodiments of the present disclosure include coated articles and methods of coating such articles. The coated articles include a calcia-magnesia-alumina-silicate (CMAS)-resistant thermal barrier coating (TBC) on a substrate (directly or with one or more intermediate layers). The CMAS-resistant TBC (also referred to herein simply as the TBC) includes pores or nanochannels in open communication with a surface thereof. The coated article also includes a solid film comprising aluminum phosphate that is disposed on and covers internal wall surfaces of the pores or nanochannels and the surface of the TBC. In some examples, the solid film does not completely fill the pores or nanochannels. The coated articles may be configured for use in high temperature operating conditions while providing CMAS resistance and erosion resistance to the underlying substrate. The coated article may be various types of components including, but not limited to, components of gas turbine engines (e.g., shrouds, blades, etc.).

To meet the needs of next generation gas turbine engines, various TBC materials are being pursued to replace conventional TBC materials such as 7 wt.% yttria stabilized zirconia (7YSZ). To be successful, these potential replacement TBC materials would likely need to provide CMAS resistance at the elevated operating temperatures expected for the next generation gas turbine engines that is better than or comparable to, for example, 7YSZ at current operating temperatures. Various replacement TBC materials are currently being researched. In experimental investigations leading to aspects of some of the examples discussed herein, it was determined that many of these potential replacement TBC materials receive little to no benefit from processes that is intended to promote CMAS-resistance, such as application of the solid film comprising aluminum phosphate discussed herein. While not intending to be limited to any particular theory, it is believed that these potential replacement TBC materials fail under the operating conditions expected for the next generation gas turbine engines due to erosion prior to receiving the benefits of CMAS resistance, for example, provided by the solid film comprising aluminum phosphate discussed herein. Surprisingly, the combination of the TBC material discussed herein comprising alumina dopants in combination with the solid film comprising aluminum phosphate provides improved CMAS-resistance without sacrificing erosion resistance. As such, it was determined that the coated articles discussed herein are capable of providing CMAS-resistance and erosion resistance at the increased operating temperatures expected for next generation gas turbine engines that are better than or substantially equivalent to those provided by conventional TBC materials (e.g., 7YSZ) at current operating temperatures.

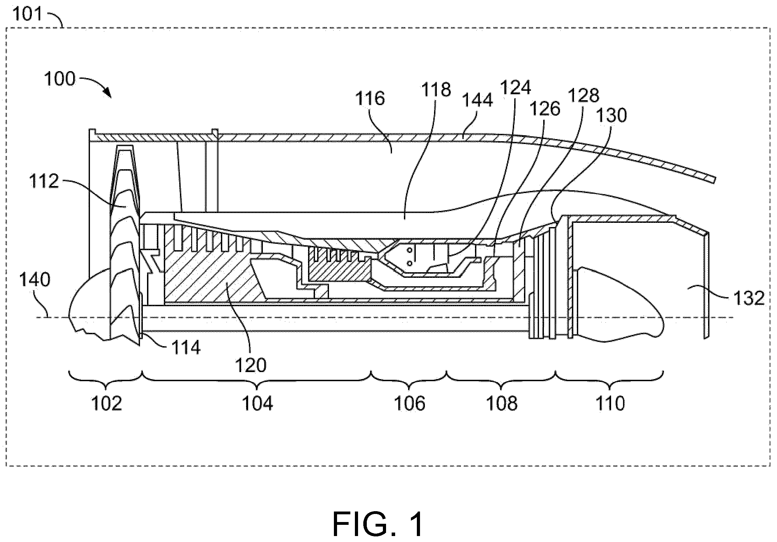

With reference to FIG. 1, a partial, cross-sectional view of an exemplary gas turbine engine 100 is shown with the remaining portion of the gas turbine engine 100 being substantially axisymmetric about a longitudinal axis 140, which also defines an axis of rotation for the gas turbine engine 100. In the depicted embodiment, the gas turbine engine 100 is an annular multi-spool turbofan gas turbine jet engine within an aircraft (represented schematically at 101), although features of the present disclosure may be included in other configurations, arrangements, and/or uses. For example, in other embodiments, the gas turbine engine 100 may assume the form of a non-propulsive engine, such as an Auxiliary Power Unit (APU) deployed onboard the aircraft 101, an industrial power generator, or other turbomachine.

In this example, with continued reference to FIG. 1, the gas turbine engine 100 includes a fan section 102, a compressor section 104, a combustor section 106, a turbine section 108, and an exhaust section 110. In one example, the fan section 102 includes a fan 112 mounted on a rotor 114 that draws air into the gas turbine engine 100 and compresses it. A fraction of the compressed air exhausted from the fan 112 is directed through the outer bypass duct 116 and the remaining fraction of air exhausted from the fan 112 is directed into the compressor section 104. The outer bypass duct 116 is generally defined by an outer casing 144 that is spaced apart from and surrounds an inner bypass duct 118.

In the embodiment of FIG. 1, the compressor section 104 includes one or more compressors 120. The number of compressors 120 in the compressor section 104 and the configuration thereof may vary. The one or more compressors 120 sequentially raise the pressure of the air and direct a majority of the high-pressure fluid or air into the combustor section 106. In the combustor section 106, which includes a combustion chamber 124, the high-pressure air is mixed with fuel and is combusted. The high-temperature combustion air or combustive gas flow is directed into the turbine section 108. In this example, the turbine section 108 includes three turbines disposed in axial flow series, namely, a high-pressure turbine 126, an intermediate pressure turbine 128, and a low-pressure turbine 130. However, it will be appreciated that the number of turbines, and/or the configurations thereof, may vary. In this embodiment, the high-temperature combusted air from the combustor section 106 expands through and rotates each turbine 126, 128, and 130. The combustive gas flow then exits the turbine section 108 for mixture with the cooler bypass airflow from the outer bypass duct 116 and is ultimately discharged from the gas turbine engine 100 through the exhaust section 132. As the turbines 126, 128, 130 rotate, each drives equipment in the gas turbine engine 100 via concentrically disposed shafts or spools.

The engine 100 may include at least one component that is or includes a coated article as discussed above, that is, comprising a substrate, a CMAS-resistant TBC on the substrate or on an intermediate layer therebetween (e.g., a bond coat), and a solid film comprising aluminum phosphate on and covering internal wall surfaces of pores or nanochannels of the TBC and an outer surface of the TBC.

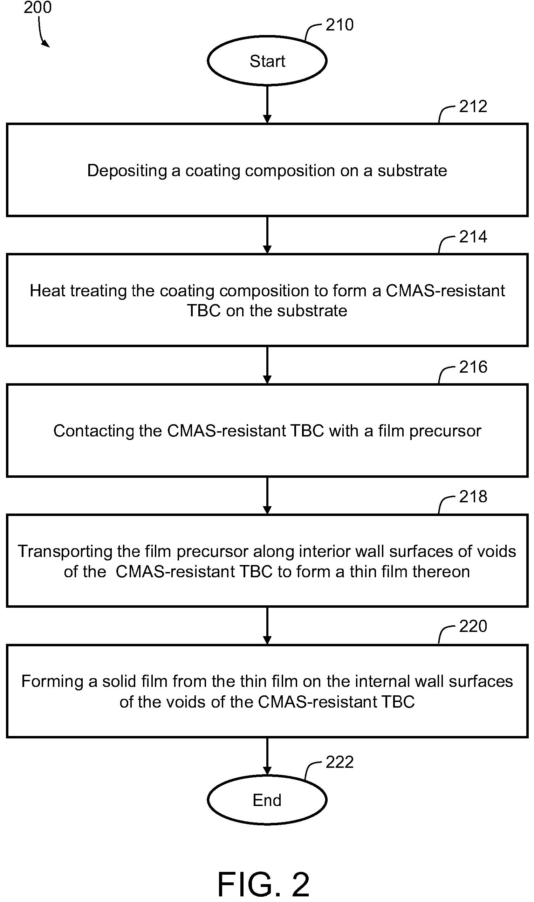

Various methods may be used to produce the component and/or the coated articles thereof. For example, FIG. 2 is a flowchart illustrating an exemplary method 200 for coating an article. The method 200 may start at 210. The method 200 may initially begin with an initial article comprising a substrate and, optionally, one or more intermediate layers formed thereon. In some examples, the substrate (e.g., part body) defines a majority of the coated article. The substrate may be made of any suitable material. In some examples, the substrate may be made of or include a metallic superalloy (e.g. a nickel-based superalloy). The substrate may also include an outer surface that may be contoured or substantially flat. For example, the outer surface may at least partly define an airfoil shape. In some examples, the coated article may include one or more intermediate layers formed thereon such as, but not limited to, a bond coat. In specific examples, the bond coat may include a thin metallic coating on the outer surface of the substrate. For example, the bond coat may include an oxidative protectant, such as a thermally-grown oxide material (e.g. aluminum oxide, etc.). Thus, the bond coat may be a metallic bond coat that provides oxidative protection of the substrate. In some examples, the bond coat may be substantially free from aluminum-containing materials.

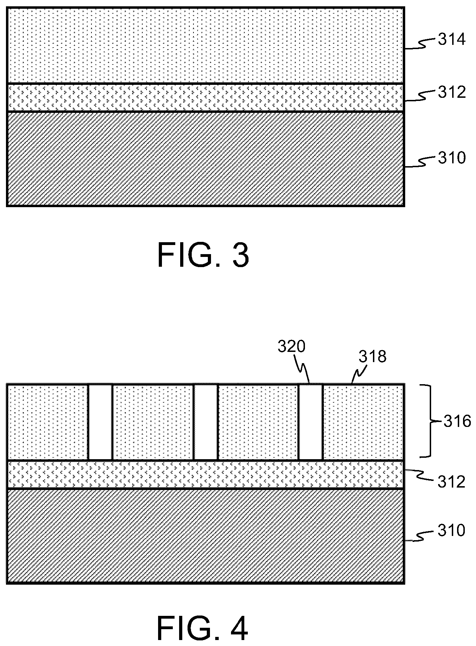

At 212, the method 200 may include depositing a coating composition on the substrate and/or the intermediate layers thereon, if any. As a nonlimiting example, FIG. 3 represents a substrate 310, an intermediate layer 312 (e.g., a bond coat) formed thereon, and a coating composition layer 314 deposited on the intermediate layer 312. The coating composition includes one or more rare-earth (RE) oxides, zirconia, and alumina. The RE oxides suitable for use are not especially limited, and may include any one or more RE oxides suitable for preparing a thermal barrier via the deposition and treatment processes provided herein. Typically, the one or more RE oxides is selected from yttria (Y₂O₃), ytterbia (Yb₂O₃), lanthana (La₂O₃), gadolinia (Gd₂O₃), scandia (Sc₂O₃), erbia (Er₂O₃), samaria (Sm₂O₃), and combinations thereof. In certain examples, the one or more RE oxides comprises at least one of yttria, lanthana, and gadolinia. In specific examples, the one or more RE oxides of the coating composition consist essentially of yttria, ytterbia, lanthana, gadolinia, erbia, or combinations thereof.

In general, the coating composition includes from about 3 to about 50 wt.% of the one or more RE oxides, based on the total weight of the coating composition. In specific examples, the coating composition includes a total of from about 3 to about 50 wt.% of the one or more RE oxides, based on the total weight of RE oxides, zirconia, and alumina utilized in the method. The particular amount of any one of the one or more RE oxides will be determined by one of skill in the art based on the desired thermal barrier material being prepared. For example, any one particular RE oxide may be utilized in the amount of from about 3 to about 50 wt.%. Alternatively, a mixture of at least two RE oxides may be used in a combined amount of from about 3 to about 50 wt.%. In this fashion, a particular RE oxide may be present in an amount of less than 3 wt.%. when combined with at least one other RE oxide, with the total weight of all RE oxides in the coating composition being from about 3 to about 50 wt.%, based on the total weight of all RE oxides, zirconia, and alumina utilized in the method.

The coating composition may include the alumina in an amount of from about 0.5 to about 4 wt.%, based on the total weight of the coating composition. In some examples, the coating composition includes the alumina in an amount of from about 0.5 to about 3.5, alternatively from about 0.5 to about 3, alternatively from about 0.5 to about 2.5, alternatively from about 0.5 to about 2 wt.%, based on the total weight of the coating composition. In other examples, the coating composition comprises the alumina in an amount of from about 1 to about 4, alternatively from about 1.5 to about 4, alternatively from about 2 to about 4, alternatively from about 2.5 to about 4 wt.%, based on the total weight of the coating composition. In certain examples, the coating composition includes the alumina in one of the aforementioned ranges, where the weight percent is based on the total combined weight of the one or more RE oxides, the zirconia, and the alumina being utilized. At the amounts provided above, the alumina provides the CMAS-resistant TBC with effective CMAS protection, and yet the CMAS-resistant TBC may still exhibit sufficiently low thermal conductivity, effective strain compliance, high erosion resistance, and high mechanical integrity. Moreover, within the provided ranges the alumina remains thermodynamically stable above a predetermined temperature limit (e.g. a typical operating temperature environment for a part coated with the CMAS-resistant TBC).

In some examples, the coating composition may further include an additional metallic component selected from niobia (Nb₂O₅), tantala (Ta₂O₅), and combinations thereof. In certain examples, the coating composition consists essentially of the one or more RE oxides, the zirconia, the alumina, and the additional metallic component selected from niobia (Nb₂O₅), tantala (Ta₂O₅), and combinations thereof.

The balance of the coating composition may include the zirconia. Specifically, the coating composition may include the zirconia in an amount of from about 45 to about 96.5 wt.%, based on the total weight of the coating composition. In certain embodiments, the coating composition includes the zirconia in an amount of from about 45 to about 96.5 wt.% based on the total combined weight of the one or more RE oxides, the zirconia, and the alumina being utilized in the method.

In specific examples, the coating composition consists essentially of from about 3 to about 50 wt.% of the one or more RE oxides, from about 45 to about 96.5 wt.% zirconia, and from about 0.5 to about 4 wt.% alumina. It will be understood that term "consists essentially of" in the context of the coating composition will at times necessarily include conventional/standard impurities present in the feedstock materials of the components described. However, in such examples, the coating composition is typically free from additional components. For example, in some examples the coating composition is substantially free from, alternatively free from, neodymia, silica compounds (e.g. silica, silicates, etc.), and/or RE aluminates. In such embodiments, the thermal barrier material of the CMAS-resistant TBC, as well as the TBC itself, are also substantially free from, alternatively free from, neodymia, silica compounds, and/or RE aluminates. In specific embodiments, the CMAS-resistant TBC is formed on a portion of a part that is free from other alumina-containing barrier coatings or layers (e.g. TBC topcoats comprising alumina, etc.).

Referring again to 212 of the method 200, depositing of the coating composition on the outer surface of the substrate or, alternatively, on an intermediate layer thereon may generally include forming a flow of the coating composition or components thereof (e.g. in the form of vapor, plasma, gas, plume, cloud, atomized particles or droplets, mist, etc.), and contacting the flow to the surface of the initial article to be coated. The particular method of forming the flow is not limited, and will be selected by one of skill in the art in view of the particular deposition process being employed, a desired structure of the thermal barrier material and TBC being prepared, etc. In some examples, the flow of the coating composition thereof is prepared from a source of the coating composition or one or more components thereof. The source may consist essentially of the coating composition or one of more components thereof, or may comprise a carrier or adjuvant to the coating process.

In some examples, the deposition may be performed via plasma spraying and the source may be a feedstock of the coating composition in the form of a powder or wire comprising, alternatively consisting essentially of, the one or more RE oxide, the zirconia, and the alumina, or a suspension of such a powder. In such examples, forming the flow generally comprises delivering the feedstock into a spray tool that utilizes a plasma jet to melt and propel the components of the coating composition (e.g. in the form of molten or semi-molten droplets) toward the surface of the substrate to be coated. The droplets flatten and adhere to the substrate to form a deposit, which is selectively grown to form the as-deposited TBC later on the surface of the substrate.

When plasma spraying is utilized, the selection of a suspension plasma spraying (SPS) process or an atmospheric plasma spraying (APS) process will be determined by one of skill in the art based on the properties of the feedstock and the desired microstructure of the TBC being prepared. For example, an SPS process may be selected when the feedstock comprises ultrafine particles (e.g. < 5 µm), which may require being suspended in a slurry by a carrier (e.g. a solvent, such as water, an alcohol, etc.) in order to be delivered to the sprayer with enough momentum to enter the plasma plume. Additionally, an SPS process may be utilized when a particular microstructure is desired, such as a columnar microstructure formed by flowing the ultrafine particles across the surface of the substrate at a shallow angle and with moderate momentum flow. Such processes may be utilized to form individual porous columns of an alumina-doped thermal barrier material. In some embodiments, the CMAS-resistant TBC prepared via an SPS process with such a columnar microstructure may exhibit high strain tolerance and/or performance similar to the CMAS-resistant TBC prepared with EB-PVD columnar structures.

In some examples, the method 200 includes plasma spraying a single feedstock comprising the one or more RE oxides, the zirconia, and the alumina. In other examples, a first feedstock comprising the one or more RE oxides and the zirconia and a second feedstock comprising the alumina, are simultaneously deposited via plasma spraying. In these other examples, the first and second feedstocks may be fed to the same plasma jet/spray tool, or instead may be sprayed via independent plasma jets/spray tools that are selectively controlled to simultaneously deposit each of the components of the coating composition (i.e., each of the one or more RE oxides, the zirconia, and the alumina) such that the as-deposited TBC layer comprises the alumina distributed substantially homogeneously throughout the thermal barrier material formed from the one or more RE oxides and the zirconia.

In certain examples, the deposition may be performed via EB-PVD, and the source of the feedstock of the coating composition may be a solid ingot of the coating composition, i.e., a solid ingot consisting essentially of the one or more RE oxides, the zirconia, and the alumina, together with the optional additional metallic component if utilized. In such examples, the weight ratios of the components may be as described herein with respect to the coating composition, such that the ingot provides a fully-formulated state of the coating composition for use in the EB-PVD process. In other examples, the EB-PVD process may be performed using two ingots, specifically, a first ingot comprising the one or more RE oxide and the zirconia, and a second ingot comprising the alumina. In such examples, the additional metallic component may be present in either the first or second ingot (if utilized). Regardless, it will be appreciated that the ratio of the respective components between the ingots will be configured to be substantially equal to the ratio of the components of the coating composition. In this fashion, the first and second ingots are simultaneously consumed to provide the coating composition in situ during the EB-PVD process and form the CMAS-resistant TBC.

When the EB-PVD process is utilized, forming the flow generally comprises vaporizing the ingot(s) (e.g. via electron bombardment) under vacuum to give the coating composition in the form of a vapor. In these examples, the vapor is directed to the surfaces to be coated and allowed to form a deposit thereon (e.g. via precipitation), which is selectively grown to give the as-deposited coating composition layer on the surface of the initial article. For example, as will be understood by those of skill in the art, the use of the EB-PVD process allows for the preparation of the CMAS-resistant TBC having individual porous columns of an alumina-doped thermal barrier material. Accordingly, in some such examples, the ingot(s) utilized in the EB-PVD process are configured to comprise the alumina in an amount above its solubility in the thermal barrier material, i.e., to prepare a deposit comprising a super-saturated solid solution of the alumina in the thermal barrier material and thus allow the growth of the alumina-doped thermal barrier material without the detriment presence of second-phase precipitates. In such examples, the CMAS-resistant TBC may exhibit little to no decrease in strain tolerance as compared to a substantially similar TBC prepared without the alumina.

As will be understood by those of skill in the art, the EB-PVD process may be carried out utilizing an EB-PVD apparatus with standard deposition parameters used in the relevant art. For example, the coating composition can be deposited onto the surfaces to be coated with a well-established pre-grown alpha alumina layer, e.g. via use of emission currents of from about 1 to about 5 amps, coating chamber temperatures of from about 875 to about 1100 °C, coating pressures of from about 2.0E-03 to about 1.5E-02 mbar, etc., and combinations thereof.

At 214, the method 200 may include heat treating the substrate with the coating composition thereon to form the CMAS-resistant TBC on the substrate (or on the intermediate layer if present). The treatment results in precipitation of the alumina to give alumina particles distributed throughout the coating composition layer, thereby forming the CMAS-resistant TBC. The heat treatment may include exposing the as-deposited coating composition layer to an elevated temperature (e.g., greater than 1000 °C).

The coating composition includes components configured to give a thermal barrier material and alumina (Al₂O₃) particles, where the alumina particles are distributed substantially homogeneously throughout the thermal barrier material in the CMAS-resistant TBC. For example, the alumina particles may be provided in a substantially uniform (i.e., even) distribution within the CMAS-resistant TBC from an inner boundary thereof to an outer boundary thereof.

It is to be appreciated that the particular structure of the thermal barrier material will influence or control the particular distribution of the alumina particles throughout the CMAS-resistant TBC. For example, where EB-PVD is utilized to deposit the coating composition, the as-deposited coating composition layer may be formed via growth of alumina-doped columns of the thermal barrier material (e.g. from a super-saturated solid solution of the alumina in the thermal barrier material). In such examples, the columnar growth may be carried out substantially unobstructed due to the absence of second-phase precipitates. As such, the method 200 may provide the CMAS-resistant TBC with reduced, minimized, or no impact on the strain tolerance of the thermal barrier material as compared to similar TBCs prepared in the absence of the alumina. In these examples, treating the as-deposited coating composition layer will typically precipitate the alumina to form the discrete alumina particles on the surface of the columns.

In certain examples, plasma spraying is utilized to deposit the coating composition, and the as-deposited coating composition layer may be formed with the alumina residing primarily within pores and inter-splat gaps of the thermal barrier material. In such examples, treating the as-deposited coating composition layer may precipitate the alumina to give the alumina particles within such pores and inter-splat gaps of the thermal barrier material.

In some examples, the alumina particles may precipitate as individual particles on the outer boundary and inside the voids at high temperatures. The alumina particles may be between approximately twenty nanometers (20 nm) to one micron (µ) in size. For example, the alumina particles may have a maximum particle size of 1 micron (µ).

The microstructure of the CMAS-resistant TBC may include a plurality of voids (i.e., pores, gaps, etc.). As an example, FIG. 4 represents a TBC 316 as including a plurality of columns 318 that extend longitudinally away from the substrate 310, with voids 320 defined between the respective columns 318. It should be noted that rear walls of the voids 320 (from the perspective of FIG. 4) have been omitted for clarity. In such a configuration, the voids 320 may increase the strain compliance of the CMAS-resistant TBC 316. For example, the substrate 310 may have a significantly higher rate of thermal expansion than the CMAS-resistant TBC 316, and the voids 320 may provide a degree of strain compliance to the CMAS-resistant TBC 316 for accommodating the thermal mismatch between the CMAS-resistant TBC 316 and the substrate 310.

Although the columns 318 and voids 320 are represented in FIG. 4 as having a uniform size, a uniform alternating arrangement, etc., those of skill in the art will recognize that those features are illustrated schematically for simplicity and appreciate that, in actuality, the columns 318 and voids 320 may not exhibit uniform size, arrangement, etc. Likewise, the columns 318 and voids 320 may not extend continuously from the intermediate layer 312, but instead, some of the columns 318 and/or voids 320 may extend from the intermediate layer 312 and may be covered over in the thickness direction by other columns 318 and/or voids 320. In other examples, the plurality of voids 320 may be represented as open, elongate gaps (i.e., cracks) between localized, elongated, (e.g. pancake-shaped splats) of the TBC 316. Likewise, the voids 320 may define randomly-distributed pores without any particular orientation relative to the outer surface of the TBC 316. In some examples, the plurality of voids 320 may be represented as open gaps or cracks oriented substantially perpendicular to the outer surface of the substrate 310. As will be readily understood by those of skill in the art, instead of including columns 318, the CMAS-resistant TBC 316 may be configured and arranged differently than illustrated without departing from the scope of the present disclosure. The arrangement of the CMAS-resistant TBC 316 (i.e., the columns 318 or other structure) provided herein are for illustration purposes, and the CMAS-resistant TBC 316 may have a different arrangements without departing from the scope of the present disclosure.

In some examples, the thermal barrier material defining the columns 318 may include pores, channels, pore channels, or nanochannels open to the surface thereof. The terms "pores", "channels', "pore channels', or 'nanochannels' may not necessarily be descriptive of the actual shape of the internal structure of the thermal barrier material, but are used to describe the network of internal spaces contained in such material and collectively described as herein as the internal pores of the thermal barrier material for convenience. In some examples, the internal pores may have varying widths or sizes with an irregular cross-section having diameters measured as mean (average) diameters. For example, the internal pores may have mean diameters of less than 300 nm, such as less than 200 nm, such as less than 100 nm, such as less than 50 nm, such as less than 30 nm, such as less than 20 nanometers.

The CMAS-resistant TBC may exhibit a low thermal conductivity for thermally protecting the underlying substrate. With regard to the thermal barrier material as a whole, the thermal barrier material may exhibit relatively low thermal conductivity i.e., to impart the low thermal conductivity to the CMAS-resistant TBC. For example, the thermal barrier material may exhibit significantly lower thermal conductivity than the material of the substrate. As such, the thermal barrier material may thermally protect the underlying substrate.

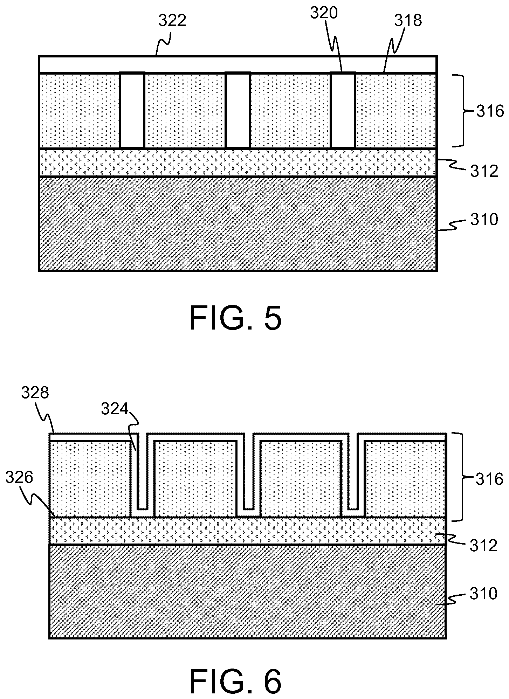

At 216, the method 200 may include contacting the CMAS-resistant TBC with a film precursor configured for infiltration of the TBC for subsequent formation of a solid film on interior wall surfaces of the voids and the interior pores of the thermal barrier material of the TBC microstructure. Various methods may be used to contact the film precursor with the TBC. In some examples, the film precursor may be applied by brushing, flowing, dipping, or spraying onto the TBC. FIG. 5 represents an as-deposited film precursor layer 322 disposed on the TBC 316.

At 218, the method 200 may include transporting the film precursor along the interior wall surfaces of the voids and the interior pores of the thermal barrier material of the CMAS-resistant TBC to form a thin film thereon. Various methods may be used to perform transportation of the film precursor.

In some examples, transportation of the film precursor is achieved by providing sufficient contact time between the film precursor and the TBC for infiltration of the TBC such that the interior wall surfaces thereof are covered. For example, the TBC may be immersed in the film precursor such that some or all of the pore openings on the surface remain covered for a time sufficient for infiltration. In another example, the film precursor may be sprayed continuously or semi-continuously onto the surface of the TBC such that some or all of the pore openings on the surface remain covered by the film precursor for a time sufficient for infiltration. Immersion or continuous contact of the surface with the film precursor may be performed for at least about 5 minutes, such as about 10-15 minutes, and may be at 20 minutes or longer as needed to permit such infiltration. Such continuous contact is distinct from mere brushing, flowing, dipping, or spraying of a liquid onto a surface in which there is insufficient time to permit liquid migration into the interior pore structure.

In some examples, transportation of the film precursor is achieved by application of an exterior gas pressure to form a pressure differential between the exterior of the TBC and the voids and interior pores. An exemplary method of providing such a pressure differential is to evacuate the TBC before applying the film precursor to the surface to be coated and then repressurizing the material. This will force film precursor into the voids and the interior pores of the thermal barrier material to form a thin layer of the film precursor onto the interior wall surfaces thereof. Alternatively, The TBC to which the film precursor has been applied may be externally pressurized to form a pressure differential which forces the film precursor into the voids and the interior pores of the thermal barrier material.

In some examples, a suitable pressure differential is about one bar, although higher or lower exterior pressures may be used. An inert gas may be used to flush out residual oxygen in the TBC. In a vacuum-assisted application method to produce an interior thin layer of the film precursor, the TBC may be evacuated to vacuum pressures of below 20 kPa (0.2 bar), such as below 10 kPa, such as below 1 kPa. In some examples, the TBC may be put under vacuum for a time period sufficient to remove trapped air to the level of the vacuum. Such time period may be up to an hour or more, such as at least 5 to 30 minutes.

In some examples, transportation of the film precursor is achieved by heating the as-deposited coating composition layer to a temperature at or above a melting temperature thereof. For example, the coating composition may include a sol-gel composition containing oxides of aluminum and phosphorus. After deposition of the coating composition onto the TBC, the coating composition layer may be dried, for example, at a mild elevated temperature (e.g., 60 to 200°C.) or reduced pressure to remove volatile organics. The remaining composition may then be cured by heating to at least the melting temperature thereof for a time sufficient to form a flowable fluid. Such fluid state may form a film or layer within the voids and the interior pores of the thermal barrier material of the TBC having a substantially uniform (e.g., < 10 % variation) phospho-alumina composition which conforms to the internal surfaces of the voids and the interior pores of the thermal barrier material. In some examples, curing temperatures may be at least 350°C, such as above 400 °C, such as above 500°C, such as 900 °C or more. A suitable curing temperature is below the disintegration temperature of the remaining composition. A suitable curing time may be a few minutes and may range from 5 minutes to up to 3 hours or more. In some examples, drying and curing may be conducted in one continuous step.

In some examples, transportation of the film precursor is achieved by liquid vaporization within the interior of the voids and the interior pores of the thermal barrier material. In some examples, the liquid vaporization may be accomplished by local heating of a vaporizable component of the coating composition to a temperature at which sufficient vapor pressure results. For an aqueous transport liquid, an exemplary temperature may be above about 40° C, such as above about 50°C, such as between about 70° C about 80°C.

In some examples, the thin film may have a thicknesses of at least about 10 nm, such as at least about 20 nm, such as at least 40 nm, and typically is less than about 150 nm, such as less than about 100 nm, such as less than 80 nm. In general, the thin film thickness may be less than half the size of a given constriction to be transported through. At these nanoscale thicknesses, the effect of viscoelastic properties becomes increasingly negligible and Van der Waals, electrostatic, and vapor pressure effects may dominate flow characteristics.

At 220, the method 200 may include forming a solid film from the thin film on the internal wall surfaces and on the surface of the CMAS-resistant TBC. Various methods may be used to perform formation of the solid film. In general, the thin film may be modified by removal of a solvent and adhesion of a solute on the interior wall surfaces as a residue. In some examples, the solvent may be removed by a drying process. In some examples, subsequent heat or other means to evaporate or decompose the thin film, the solute residue may be further modified (e.g., undergo a chemical transformation under the conditions used to remove the solvent) and bonded to the interior wall surfaces. In some examples, the heating or other means may be performed under vacuum or atmospheric conditions to remove substantial portions of the solvent, either leaving a layer of solid material to define the solid film or a precursor thereof, or to convert the thin film from a liquid state to a solid state.

In some examples, because the thin film was thin and uniform within the voids and the interior pores of the thermal barrier material, the resulting solid film may also be thin, uniform, and highly conformal to the morphology of the interior wall surfaces. In some examples, the voids of the TBC are not filled completely with the solid film.

The film precursor may have various compositions configured to infiltrate the TBC and form the solid film that includes aluminum phosphate on the internal wall surfaces thereof. In some examples, the film precursor may include a high concentration of phosphorus-containing alumina material. In some examples, the film precursor may include solids yields in a range from at least 100 g/L (i.e. will produce at least 10 wt.% solids) and may range to 300 g/L or above for alumina coating compositions. In some examples, the film precursor has an aluminum-to-phosphorus atomic ratio of at least 0.5:1, such as at least 1:1, such as at least 2:1, such as at least 4:1, such as up to 10:1, such as up to 15:1, such as up to 20:1 or above. In some examples, the film precursor may be configured to produce the solid film with phospho-aluminas that include Al-Al linkages and may contain [PO4] tetrahedra groups linked to [AlO4] tetrahedra groups, which in turn are linked to [AlO6] octahedral groups. These phospho-aluminas therefore are distinct from aluminophosphate polymorphs that exist in tetrahedral coordination.

In some examples, the film precursor may have a viscosity sufficiently low to permit permeation (i.e., near complete infiltration) of the liquid into the voids and the interior pores of the thermal barrier material under the pressure differential conditions used. In some examples, the film precursor may be an alcohol solution, such as methanol or ethanol, and may have a kinematic viscosity of below 150 centistokes (cSt), such as below 100 CSt, such as below 60 cSt, such as below 50 cSt, such as below 30 cSt, such as below 20 cSt. In a specific example, the film precursor contains ethanol, methanol, or combination thereof and has a viscosity below 35 cSt. The low viscosity liquid should have low surface tension to facilitate infiltration into fine channels and pores. Viscosity may be measured according to ASTM D446.

In some examples, the film precursor may be a sol-gel containing oxides of aluminum to which oxides of phosphorus are incorporated, which may be cured by heating to a temperature sufficient to form a phospho-alumina. In such examples, the film precursor may be formed in a non-aqueous liquid such as an alcohol and in conditions having a of pH less than two. For example, a low viscosity, non-colloidal solution may be formed by combining an aluminum salt in an alcoholic solution with an alcoholic solution of a phosphate ester or precursor of a phosphate ester. An exemplary alcohol solvent is a C, -C4 monohydroxy alcohol including methanol, ethanol, n-propanol, iso-propanol, n-butanol, 2-butanol, and t-butanol and combinations thereof. In an exemplary procedure, alcohol solutions of an aluminum salt (such as aluminum nitrate or aluminum acetate) and a phosphorus oxide such as phosphorus pentoxide (P₂0₃) or phosphorus oxide ester are combined in aluminum to phosphorus atomic ratios suitable for creating a desired layer of the solid film. The alcohol solution of a phosphorus pentoxide may result in an ester of a phosphorus oxide or phosphate. In some examples, the concentration of a phospho-alumina film precursor may be at least about 1 molar (M), such as 1.5 M or above, and may range up to 3 M or above wherein the molarity / concentration is the number of moles of Al per liter of solution. In some examples, the phospho-alumina precursor may be 1 to 2.75 M, such as 1.5 to 2.5 M. Use of lower phospho-alumina precursor concentrations (e.g., > 0.3 M) may require additional coatings to form the solid film, which may be inefficient. In some examples, the film precursor is halide free. Examples of phosphorus-alumina coating systems are described in U.S. Pat. Nos. 6,036,762, 6,461,415, 7,311,944, 7,678,465, 7,682,700, all incorporated by reference herein.

In some examples, the film precursor may include at least one solute and at least one vaporizable component. A suitable vaporizable component (e.g., transporting liquid), should be capable of a phase transition from a liquid to a gas within the voids and the interior pores of the thermal barrier material of the TBC under processing conditions. A suitable vaporizable component acts to drive liquid transport by induced internal liquid vaporization. In some examples, the film precursor may include, as vaporizable component(s), water or water in combination with an alcohol. In some examples, the film precursor may include at least 5 wt.%., such as at least 25 wt.%, such as at least 50 wt.% vaporizable component(s). Exemplary vaporizable components may include polar and non-polar liquids including organic solvents such as C-Co alcohols, aldehydes, ketones, ethers, hydrocarbons, halogenated hydrocarbons, aromatics, aliphatics, and the like. In some examples, the vaporizable component(s) are capable of solvating a solute that will be placed onto the interior wall surfaces of the voids and the interior pores of the thermal barrier material.

In some examples, suitable solutes should be soluble in the film precursor under conditions used and may be capable of adhering or functionalizing the interior wall surfaces of the voids and the interior pores of the thermal barrier material. In general, the solute may be transported along the interior wall surfaces together with the vaporizing component(s). Upon pyrolysis/decomposition or evaporation of the vaporizing component(s), the solute may form a coating of a solid residue on the interior wall surfaces. In some examples, multiple layers of the solid residue may be created by repeated treatments to form the solid film.

The method 200 may end at 222.

Referring now to FIG. 6, a portion of a part of the gas turbine engine 100 is represented. It will be appreciated that the part may be one of a variety of parts of the gas turbine engine 100 without departing from the scope of the present disclosure. The part may have an airfoil shape. In some embodiments, the part may be included in an area of the engine 100 subjected to high-temperature environments. Thus, the part may be a component of the combustor section 106, a component of the turbine section 108, etc. More specifically, the part may be a blade, a vane, or other component of the turbine section 108. It will also be appreciated that the part may be a component of something other than the gas turbine engine 100 without departing from the scope of the present disclosure.

The part includes a coating system thereon that includes the CMAS-resistant TBC 316 and the solid film 324. The CMAS-resistant TBC 316 generally includes an inner boundary 326 that faces the substrate 310 (and optionally the intermediate layer 312), and an outer boundary 328 that faces away from the substrate 310. In some examples, the CMAS-resistant TBC 316 may have a thickness of from about 4 to about 8 mil (e.g. from about 0.1 to about 2 mm).

The CMAS-resistant TBC 316 includes a thermal barrier material (e.g. a ceramic) prepared via the selective deposition of the one or more RE oxides and the zirconia. The CMAS-resistant TBC 316 also includes alumina dopants distributed substantially homogeneously throughout the thermal barrier material. In particular, the CMAS-resistant TBC 316 may be prepared to include distributed alumina particles inside pores and gaps (e.g. inter-columnar gaps) defined by the thermal barrier material, which composes a majority of the CMAS-resistant TBC 316. In this fashion, the CMAS-resistant TBC 316 is configured to prevent CMAS infiltration, reduce subsequent penetration, and/or mitigate other detrimental CMAS-induced effects by providing a reactive component (e.g. the alumina particles) to react with CMAS materials, fill interstitial spaces via the reaction, and thus block both infiltration and penetration of CMAS materials in portions vulnerable in conventional TBCs. Moreover, the CMAS-resistant TBC 316 is provided with low thermal conductivity and high fracture toughness. Accordingly, the method of the present embodiments provides the CMAS-resistant TBC 316 as a TBC exhibiting desirable physical and performance properties, while also being effective at reducing CMAS material infiltration and related detriments, such as material stiffening and loss of strain compliance, as compared to conventional TBCs.

The solid film 324 is formed over the internal wall surfaces of voids and the interior pores of the thermal barrier material of the TBC 316. It should be noted that rear walls of the voids (from the perspective of FIG. 6) have been omitted for clarity. The solid film 324 includes aluminum phosphate. In some examples, the internal wall surfaces of the voids and the interior pores of the thermal barrier material are coated by the solid film 324 without blocking or filling voids and the interior pores of the thermal barrier material having diameters of more than 30-50 nm. Thus, most of the voids and the interior pores of the thermal barrier material may be open and in open communication with the surface. This promotes retention of properties of the porous TBC 316 such as thermal barrier protection and stress fracture resistance. The solid film 324 may be formed of a single layer or a combination of two or more sublayers. In some examples, the solid film 324 includes two or more sublayers that are each about 1 to 50 nm thick. In some examples, the solid film 324 has a thickness of at least 5 nm, such as at least 10 nm, such as at least 20 nm, and may have a thickness of up to 500 nm, such as up to 300 nm, such as up to 100 nm thick. In some examples, the density of the TBC 316 may not change significantly due to the presence of the solid film 324. In some examples, the density of the TBC 316 may be changed by the presence of the solid film 324 by less than 10%, such as less than 5%, such as less than 1%.

The systems and methods disclosed herein provide various benefits over certain existing systems and methods. For example, it is desirable for TBCs to have both high CMAS resistance and high erosion resistance while operating in the operating conditions expected for next generation gas turbine engines. However, many of the TBC materials currently being researched have insufficient erosion resistance to survive these expected operating conditions. Furthermore, it has been found that many of these potential TBC materials experience a reduction of erosion resistance from the formation of CMAS resistance coatings thereon. In contrast, the methods provided herein allow for coating of a TBC, particularly a TBC having alumina dopants as described herein, to form the solid film thereon to promote CMAS resistance with little to no reduction in erosion resistance, and thereby provide coated articles capable of surviving the operating conditions expected for next generation gas turbine engines.
In some examples, the coated articles discussed herein are capable of providing CMAS-resistance and erosion resistance at the increased operating temperatures expected for next generation gas turbine engines that are better than or substantially equivalent to those provided by conventional TBC materials (e.g., 7YSZ) at current operating temperatures.

In this document, relational terms such as first and second, and the like may be used solely to distinguish one entity or action from another entity or action without necessarily requiring or implying any actual such relationship or order between such entities or actions. Numerical ordinals such as "first," "second," "third," etc. simply denote different singles of a plurality and do not imply any order or sequence unless specifically defined by the claim language. The sequence of the text in any of the claims does not imply that process steps must be performed in a temporal or logical order according to such sequence unless it is specifically defined by the language of the claim. The process steps may be interchanged in any order without departing from the scope of the invention as long as such an interchange does not contradict the claim language and is not logically nonsensical.

Furthermore, depending on the context, words such as "connect" or "coupled to" used in describing a relationship between different elements do not imply that a direct physical connection must be made between these elements. For example, two elements may be connected to each other physically, electronically, logically, or in any other manner, through one or more additional elements.

As used herein, the term "axial" refers to a direction that is generally parallel to or coincident with an axis of rotation, axis of symmetry, or centerline of a component or components. For example, in a cylinder or disc with a centerline and generally circular ends or opposing faces, the "axial" direction may refer to the direction that generally extends in parallel to the centerline between the opposite ends or faces. In certain instances, the term "axial" may be utilized with respect to components that are not cylindrical (or otherwise radially symmetric). For example, the "axial" direction for a rectangular housing containing a rotating shaft may be viewed as a direction that is generally parallel to or coincident with the rotational axis of the shaft. Furthermore, the term "radially" as used herein may refer to a direction or a relationship of components with respect to a line extending outward from a shared centerline, axis, or similar reference, for example in a plane of a cylinder or disc that is perpendicular to the centerline or axis. In certain instances, components may be viewed as "radially" aligned even though one or both of the components may not be cylindrical (or otherwise radially symmetric). Furthermore, the terms "axial" and "radial" (and any derivatives) may encompass directional relationships that are other than precisely aligned with (e.g., oblique to) the true axial and radial dimensions, provided the relationship is predominantly in the respective nominal axial or radial direction. As used herein, the term "substantially" denotes within 5% to account for manufacturing tolerances. Also, as used herein, the term "about" denotes within 5% to account for manufacturing tolerances.

While at least one exemplary embodiment has been presented in the foregoing detailed description of the invention, it should be appreciated that a vast number of variations exist. It should also be appreciated that the exemplary embodiment or exemplary embodiments are only examples, and are not intended to limit the scope, applicability, or configuration of the invention in any way. Rather, the foregoing detailed description will provide those skilled in the art with a convenient road map for implementing an exemplary embodiment of the invention. It being understood that various changes may be made in the function and arrangement of elements described in an exemplary embodiment without departing from the scope of the invention as set forth in the appended claims.

## Claims

1. A method, comprising:
depositing a coating composition on a substrate, the coating composition comprising:
from about 3 to about 50 wt.% of one or more rare-earth oxides;
from about 45 to about 96.5 wt.% zirconia; and
from about 0.5 to about 4 wt.% alumina, each based on the total weight of the coating composition;
heat treating the substrate with the coating composition thereon to form a calcia-magnesia-alumina-silicate (CMAS)-resistant thermal barrier coating (TBC) on the substrate, wherein the CMAS-resistant TBC includes a columnar microstructure with voids in open communication with a surface thereof, wherein the alumina is deposited homogeneously throughout the CMAS-resistant TBC;
contacting the CMAS-resistant TBC with a film precursor;
transporting the film precursor along interior wall surfaces of the voids of the CMAS-resistant TBC to form a thin film thereon, wherein the thin film has a thickness on the interior wall surfaces of at least 10 nm and less than 150 nm; and
forming a solid film on the interior wall surfaces of the voids from the film precursor, wherein the solid film includes aluminum phosphate, wherein the solid film does not completely fill at least some of the voids that have diameters of 50 nm or greater.

2. The method of claim 1, wherein the CMAS-resistant TBC is free from second phase precipitates.

3. The method of claim 1, wherein the alumina in the CMAS-resistant TBC have a maximum particle size of about 1 µm.

4. The method of claim 1, wherein transporting the film precursor along the interior wall surfaces of the voids includes maintaining contact between the film precursor and the CMAS-resistant TBC for at least five minutes, and producing a pressure differential between an exterior of the CMAS-resistant TBC and the interior wall surfaces of the voids.

5. The method of claim 1, wherein transporting the film precursor along the interior wall surfaces of the voids includes vaporizing a vaporizable component of the film precursor.

6. The method of claim 1, further comprising producing the film precursor to have a viscosity of 150 cSt or less and a solids yield of at least 100 g/L and an aluminum-to-phosphorus atomic ratio of at least 0.5:1.

7. The method of claim 1, wherein forming the solid film on the interior wall surfaces includes drying the thin film to produce a solid residue on the interior wall surfaces.

8. The method of claim 1, further comprising:
transporting the film precursor along interior wall surfaces of internal pores of a thermal barrier material of the CMAS-resistant TBC, wherein the internal pores have diameters of 300 nm or less that are open to surfaces of the thermal barrier material; and
forming the solid film on the interior wall surfaces of the internal pores from the film precursor.

9. The method of claim 1, wherein the solid film has a thickness on the interior wall surfaces of the voids of at least 5 nm and up to 500 nm.

10. A component of a gas turbine engine, comprising:
a substrate;
a calcia-magnesia-alumina-silicate (CMAS)-resistant thermal barrier coating (TBC) on the substrate, wherein the CMAS-resistant TBC is formed from a coating composition comprising from about 3 to about 50 wt.% of one or more rare-earth oxides, from about 45 to about 96.5 wt.% zirconia, and from about 0.5 to about 4 wt.% alumina, each based on the total weight of the coating composition, wherein the alumina is homogeneously distributed throughout the CMAS-resistant TBC, wherein the CMAS-resistant TBC includes a columnar microstructure with voids in open communication with a surface thereof; and
a solid film on the interior wall surfaces of the voids of the CMAS-resistant TBC, wherein the solid film includes aluminum phosphate, wherein the solid film does not completely fill at least some of the voids that have diameters of 50 nm or greater.

11. The component of claim 10, wherein the CMAS-resistant TBC is free from second phase precipitates.

12. The component of claim 10, wherein the alumina in the CMAS-resistant TBC have a maximum particle size of about 1 µm.

13. The component of claim 10, wherein the one or more rare-earth oxides of the CMAS-resistant TBC are selected from the group consisting of yttria, ytterbia, lanthana, gadolinia, niobia, tantala, scandia, erbia, lanthana, samaria, and combinations thereof.

14. The component of claim 10, wherein the CMAS-resistant TBC includes a thermal barrier material having internal pores having diameters of 300 nm or less that are open to surfaces of the thermal barrier material and the solid film covers interior wall surfaces of at least some of the internal pores.

15. The component of claim 10, wherein the solid film has a thickness on the interior wall surfaces of the voids of at least 5 nm and up to 500 nm.
